# EUROPEAN PATENT SPECIFICATION

(11) **EP 1 936 684 B1**
(45) Date of publication and mention of the grant of the patent: **20.07.2011**
(21) Application number: 07121276.5
(22) Date of filing: 22.11.2007
(51) Int. Cl.: H01L 23/367, H05K 1/02

(54) **Electronic device with a base plate**
Elektronische Vorrichtung mit einer Bodenplatte
Dispositif électronique avec plaque de base

(30) Priority: 22.12.2006 EP 06026658
(43) Date of publication of application: 25.06.2008
(73) Proprietor: ABB Technology AG, 8050 Zürich (CH)
(72) Inventor: Chen, Makan, CH-5102, Rupperswil (CH); Schneider, Daniel, CH-8112, Otelfingen (CH); Zehringer, Raymond, CH-4132, Muttenz (CH)
(74) Representative: ABB Patent Attorneys

(56) References cited:
- US-A- 5 784 256
- KEVIN A MOORES ET AL: "Thermal Characterization of a Liquid Cooled AlSiC Base Plate with Integral Pin Fins" IEEE TRANSACTIONS ON COMPONENTS AND PACKAGING TECHNOLOGIES, IEEE SERVICE CENTER, PISCATAWAY, NJ, US, vol. 24, no. 2, June 2001 (2001-06), XP011011233 ISSN: 1521-3331
- HAYASHI K ET AL: "Improvement of fatigue life of solder joints by thickness control of solder with wire bump technique" 2002 PROCEEDINGS 52ND. ELECTRONIC COMPONENTS AND TECHNOLOGY CONFERENCE. ECTC 2002. SAN DIEGO, CA, MAY 28 - 31, 2002, PROCEEDINGS OF THE ELECTRONIC COMPONENTS AND TECHNOLOGY CONFERENCE, NEW YORK, NY : IEEE, US, vol. CONF. 52, 28 May 2002 (2002-05-28), pages 1469-1474, XP010747830 ISBN: 0-7803-7430-4
- M. MUENZER, M. THOBEN, A. VOLKE: "The Next Chapter in Automotive Electronics" POWER SYSTEMS DESIGN EUROPE, [Online] October 2006 (2006-10), pages 40-43, XP002471958 Retrieved from the Internet: URL:http://www.powersystemsdesign.com/auto motive06_2.pdf> [retrieved on 2008-03-07]

## Description

### Technical Field

The invention relates to the field of power electronics and more particularly to an electronic device with a base plate for a heat sink according to the preamble of claim 1.

### Background Art

State of the art is known from the paper by K. Hayashi et al. "Improvement of fatigue life of solder joints by thickness control of solder with wire bump technique" 2002 Proceedings 52nd. Electronic Components and Technology Conference. ECTC 2002, San Diego, CA, May 28-31, 2002, Proceedings of the Electronic Components and Technology Conference, New York, NY: IEEE, US vol. CONF. 52, 28 May 2002, pages 1469-1474 ISBN: 0-7803-740-4.

WO 2004/065050 describes a method to solder a capacitor to a printed circuit board (PCB). In order to achieve a defined thickness of the solder layer between the capacitor and the PCB, the solder paste contains a solder material and a spacer material, which has a melting point higher than the melting point of the solder material. Typically, the spacer material is in form of spheres. During heating of the solder paste, the solder paste is heated to a temperature that is higher than the melting point of the solder material, but lower than the melting point of the spacer material. The spacer material stays as a solid in the paste, so that the capacitor and the PCB are spaced at a predetermined thickness from each other after the heating process. The distance between the capacitor and PCB can be varied by varying the dimensions of the spacer material in the solder paste.

US 5 784 256 refers to a notebook with a printed circuit board (PCB) including a heat generating IC chip. The chip on the PCB is cooled by clamp contacting the PCB between a cover and a cooling plate having four bosses with holes for inserting screws. The cover and cooling plate with the PCB in between are clamped together by inserting screws from the cover to the holes in the cooling plate. Between the chip and the cooling plate, which is made of a metal with high electrical and thermal conductivity, an electrically and thermally conductive layer is arranged.

### Disclosure of Invention

It is an object of the invention to provide an electronic device with a base plate for a heat sink, which allows metallurgical bonding of the base plate to a power electronic component without the danger of tilting of the base plate against the power electronic component and which base plate is easy to manufacture.
This object is achieved by an electronic device comprising at least one power electronic component, an electrically insulating plate and a base plate according to claim 1.
The inventive electronic device comprises a base plate with a cooling plate and spacer elements, which are arranged on the surface of the cooling plate. The spacer elements and the cooling plates are made as one piece with the material at least in the surface region of the cooling plate and the spacer elements being the same.
The inventive electronic device with a base plate has the advantage that the base plate allows to achieve a predetermined distance to a power electronic component, which is metallurgical bonded to the base plate. A tilting of the power electronic component against the base plate is minimised by the introduction of spacer elements on the cooling plate, which tilting would lead to different thermal extension of the areas of the bonding layer with different bonding layer, e.g. solder layer thicknesses. In that case heat distribution would be worse in the areas of greater solder thickness, because the solder material has typically a worse heat conductivity than the base plate itself or the electronic element. Additionally, there would be a danger of a delamination of the power electronic component from the base plate in case of extended thermal cycling.
With the inventive electronic device with a base plate, any solder material, suitable for achieving the desired connection between the base plate and the power electronic component in terms of temperature during the soldering and thermal properties of the solder layer can be used.
Furthermore, with such an inventive electronic device with a base plate heat can be distributed in a uniform way between the heat producing parts of a power electronic component and the base plate, if the spacer elements are arranged in areas of the base plate, which are not directly below the heat producing part of the power electronic component.

### Brief Description of Drawings

The subject matter of the invention will be explained in more detail in the following text with reference to the attached drawings, in which:
- FIG 1: shows a perspective view on a first embodiment of the base plate for a heat sink according to the invention;
- FIG 2: shows a cross sectional view on a detail of another embodiment of the base plate for a heat sink according to the invention;
- FIG 3: shows a cross sectional view on a detail of another embodiment of the base plate for a heat sink according to the invention;
- FIG 4: shows a top view on another embodiment of the base plate for a heat sink according to the invention;
- FIG 5: shows a top view on another embodiment of the base plate for a heat sink according to the invention; and
- FIG 6: shows a cross sectional view on an inventive semiconductor module.

The reference symbols used in the figures and their meaning are summarized in the list of reference symbols. Generally, alike or alike-functioning parts are given the same reference symbols. The described embodiments are meant as examples and shall not confine the invention.

### Modes for Carrying out the Invention

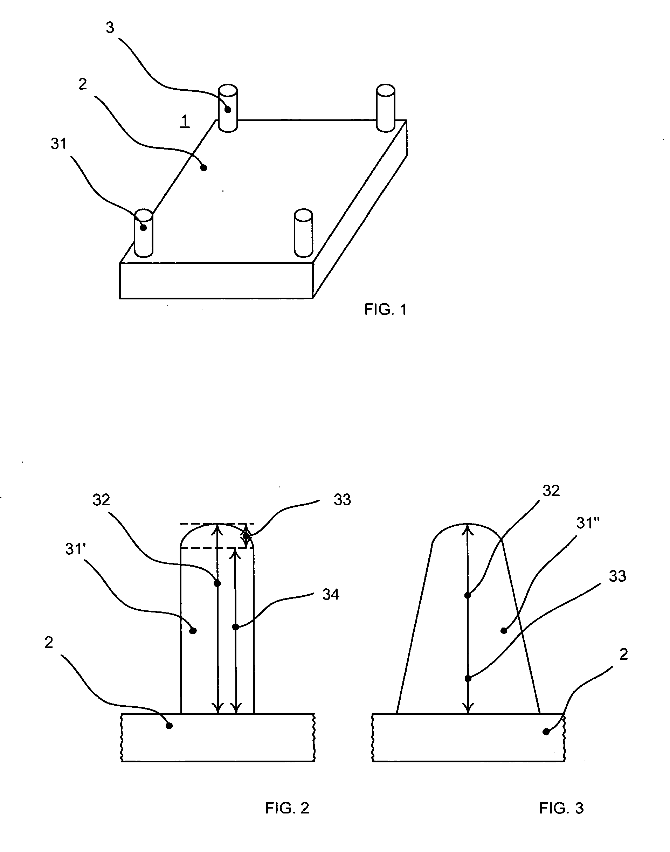

In FIG. 1 a base plate 1 for a heat sink according to the invention is shown. The base plate 1 comprises a cooling plate 2 and spacer elements 3, which are arranged on the surface of the cooling plate 2. The spacer elements 3 and the cooling plate 2 are made as one piece and the material at least in the surface region of the cooling plate 2 and of the spacer elements is the same. Of course, the cooling plate can also be completely made of said material.
Typically the cooling plate 2 is made of a metal matrix composite, e.g. a Silicon-Carbide (SiC) preform infiltrated with molten Aluminum. For the manufacturing of such a metal matrix composite the SiC preform is placed in a mold, which has the negative form of the desired final base plate 1 and then the preform is infiltrated with the Aluminum. For an inventive base plate the mold comprises recesses, by which in the final base plate 1 spacer elements 3 are formed.
The spacer elements 3, as shown in FIG. 1, are made in the form of small pins 31. In a preferred embodiment the pins 31 have a diameter of less than 2 mm x 2 mm, in particular 1 mm x 1 mm in order to have only a small influence to heat distribution and homogeneous thermal expansion coefficient of the solder layer.
The spacer elements 3 and the cooling plate 2 are made as one piece and the material in the surface region of the cooling plate 2 and of the spacer elements 3 is the same. For a metal matrix composite that means that the pins 31 are preferably made of Aluminum in the same step as the infiltration with Aluminum.
In another preferred embodiment the pins 31 extend the surface of the cooling plate 2 to a height 32 between 50 to 200 µm. The minimum height of the pins 31 is given by the maximum unevenness of the surfaces of the power electronic component and the cooling plate 2, whereas the maximum height of the pins 31 is defined by thermal resistance of the solder joint. The pins 31 may have any appropriate cross section like a quadrangular cross section, in particular a square or a rectangular cross section or a round cross section, in particular a circular or an oval cross section. The cross section can be chosen for reasons of easy manufacturing or for geometrical reasons in the final electronic device.
In FIG. 2 a detail, in particular a pin 31', of another preferred embodiment of the base plate 1 is shown. The cross section of the pin 31' diminishes with the distance from the surface of the cooling plate 2 at least in the top area of the pins 31'. The diminution of the cross section can be limited to the top area of the pins 31' in a length region 33 between 90 % and 100 % of the height 32 of each pin 31', leaving the pin 31' in a length region 34 between the surface of the cooling plate 2 and 90 % of the height 32 of the pin 31' with a constant cross section. In another preferred embodiment, the diminution in the cross section of the pins 31' is limited to the top area of the pins 31' in the length region 33 of 75 % to 100 % of the height 32 of each pin 31', in particular in a length region 33 of 50 % to 100 % of the height 32 of each pin 31', and in particular over the whole height 32 of each pin 31', as shown for a pin 31" in FIG. 3. In another embodiment, the cross section diminishes continuously. The advantage of such pins 31' or 31" with a decreasing cross section with the distance from the surface of the cooling plate 2 is that thermal stress due to different thermal extension in the transition area between insulating plate 8, the pin 31', 31" and the solder layer is avoided or at least reduced.

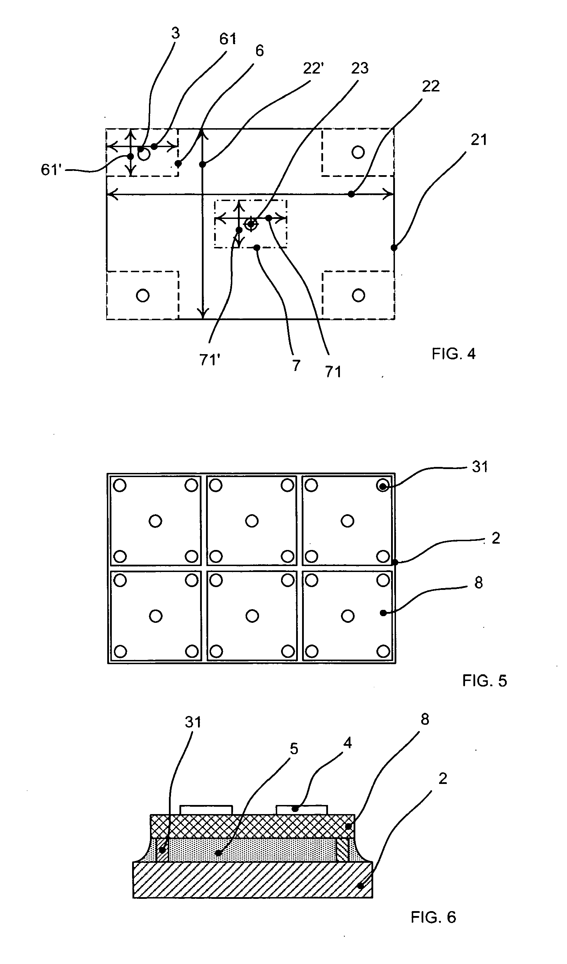

In FIG. 4 a top view on a base plate 1 is shown. The cooling plate 2 is in form of a first rectangular 21 and the pins 31 are arranged in the four corners of the cooling plate 2. In particular, the pins 31 are arranged within an area corresponding to a second rectangular 6 with a side length 61, 61' corresponding to a quarter of the parallel lying side length 22, 22' of the cooling plate 2. The side length 61 of the second rectangular lies parallel to the side length 22 of the first rectangular, and the side length 61' parallel to the side length 61'. The second rectangular 6 extends on the surface of the cooling plate 2 from a corner of the cooling plate 2. The area in which the pins 31 are arranged should be chosen in such a way that no heat producing part of the electronic component is arranged directly above the pins 31', thereby avoiding a reduction of heat transfer capability in the region of the pins 31.
Another preferred embodiment of the inventive base plate 1 is also shown in FIG. 4. A pin 31 is arranged around the centre in the middle part of the cooling plate 2, in particular within an area around the centre of the cooling plate 2, the area corresponding to a third rectangular 7 with a side length 71, 71' corresponding to a quarter of the parallel lying side length 22, 22' of the cooling plate 2. In another preferred embodiment, the pin 31 is arranged in the centre 23 of the first rectangular 21. Of course, the cooling plate 2 can have other forms than a first rectangular 21, and in a preferred embodiment, not shown in a figure, pins 31 are arranged in the corners of the cooling plate 2 or outer areas, which border on the edge of the cooling plate 2.

In FIG. 6 an inventive electronic device in form of a semiconductor module is shown, which comprises at least one power electronic component in form of a semiconductor chip 4 and an inventive base plate 1. The semiconductor chips 4 can be insulated gate bipolar transistors (IGBT).
The at least one semiconductor chip 4 is bonded by a metallurgical process, preferably by soldering or metal bonding, on an electrically insulating plate 8, which is typically a ceramic substrate. The insulating plate 8 is plate is bonded by a metallurgical process, in particular by soldering, on the side, which lies opposite the side, on which the at least one semiconductor chip 4 is arranged, on the base plate 1. Also low temperature bonding can be used as a metallurgical bonding for one or both bondings. Such low temperature bondings are typically made under high pressure and temperatures typically below 300 °C. Metals like silver and indium or tin and gold are used for making the joint. The metals are applied on the surfaces to be jointed together as thin sheets and/or as a powder. Such low-tempereature bonding methods are for example described in PCT/CH2006/00610.
These metallurgical bondings are non-detachable connections, i.e. the connections are destroyed if trying to separate the two elements bonded together under normal conditions.
In another preferred embodiment, shown in Fig. 5, a plurality of such insulating plates 8 (in this case: six), each with at least one semiconductor chip 4 arranged on one side, are arranged together on one base plate 1. At least four pins 31 are arranged on the base plate 1 for a contact with each insulating plate 8. In a preferred embodiment, the insulating plate(s) 8 is rectangular and these pins 31 are arranged on the base plate 1 such that they can make contact to the four corners of each insulating plate 8. More generally, the pins 31 are arranged outside the projected area, in which the at least one semiconductor chip 4 is arranged. A further pin 31 may be arranged in the middle part, in particular in the centre of each insulating plate 8. Any other number of insulating plates, i.e. one or more, are arrangeable on the base plate 1, each with pins 31 arranged in such a way that the pins 31 can make contact to the corners of each insulating plate 8 in the described manner.
In another preferred embodiment, not shown in a figure, the inventive base plate 1 is thermally and electrically conductive connected to the at least one semiconductor chip 4.

### Reference List

- 1: Base plate
- 2: Cooling plate
- 21: First rectangular
- 22, 22': Side length
- 23: Centre
- 3: Spacer element
- 31, 31', 31: " Pins
- 32: Height
- 33: Length region
- 34: Length region
- 4: Semiconductor chip
- 5: Solder layer
- 6: Second rectangular
- 61, 61': Side length
- 7: Third rectangular
- 71, 71': Side length
- 8: insulating plate

## Claims

1. Electronic device comprising at least one power electronic component, in particular at least one semiconductor chip (4), an electrically insulating plate (8) and a base plate (1), wherin the base plate comprises a cooling plate (2), wherein the at least one power electronic component is metallurgically bonded, in particular by soldering, metal or low-temperature bonding, on the electrically insulating plate (8), in particular on a ceramic substrate, which electrically insulating plate (8) is metallurgically bonded, in particular by soldering or low-temperature bonding, on the base plate (1), and wherein spacer elements (3) are arranged between the insulating plate (8) and the cooling plate (2), **characterized in that** the base plate (1) comprises the spacer elements (3), which are arranged on the surface of the cooling plate (2), the spacer elements (3) and the cooling plate (2) being made as one piece and the material in the surface region of the cooling plate (2) and of the spacer elements being the same.

2. Electronic device according to claim 1, **characterized in that** the spacer elements (3) are pins (31, 31', 31 ").

3. Electronic device according to claim 2, **characterized in that** the pins (31, 31', 31 ") have a cross section of less than 2 mm x 2 mm, in particular 1 mm x 1 mm.

4. Electronic device according to claim 2 or 3, **characterized in that** the pins (31, 31', 31 ") extend the surface of the cooling plate (2) to a height (32) between 50 to 200 µm.

5. Electronic device according to claim 2 or 3, **characterized in that** the pins (31, 31', 31 ") have a round cross section, in particular a circular or an oval cross section.

6. Electronic device according to claim 2 or 3, **characterized in that** the pins (31, 31', 31 ") have a quadrangular cross section, in particular a square or a rectangular cross section.

7. Electronic device according to claim 2 to 6, **characterized in that** the cross section of the pins (31, 31', 31 ") diminishes with the distance from the surface of the cooling plate (2) at least in the top area of the pins (31, 31', 31"), in particular in a length region (33) between 90 and 100 % of the height (32) of each pin (31, 31', 31 "), in particular in a length region (33) of 75 to 100 % of the height (32) of each pin (31, 31', 31 "), in particular in a length region (33) of 50 to 100 % of the height (32) of each pin (31, 31', 31"), and in particular over the whole height (32) of each pin (31, 31', 31 ").

8. Electronic device according to claim 2 to 7, **characterized in that** the cooling plate (2) is a first rectangular (21) and the pins (31, 31', 31") are arranged in the four corners of the cooling plate (2), each in particular within an area corresponding to a second rectangular (6), which second rectangular (6) extends on the surface of the cooling plate (2) from a corner of the cooling plate (2) with a side length (61, 61') corresponding to a quarter of the side length (22, 22') of the cooling plate (2), which side of the cooling plate (2) lies parallel to the side of the second rectangular (6).

9. Electronic device according to claim 8, **characterized in that** a pin (31, 31', 31 ") is arranged in the middle part of the first rectangular (21), in particular within an area around the centre corresponding to a third rectangular (7) with a side length (71, 71') corresponding to a quarter of the side length (22, 22') of the cooling plate (2), which side of the cooling plate (2) lies parallel to the side of the third rectangular (7), and in particular in the centre (23) of the first rectangular (21).

10. Electronic device according to claim 2 to 7, **characterized in that** the base plate (1) is metallurgically bonded to at least one insulating plate (8), each with at least one power electronic component arranged on a side opposite the base plate (1), and **in that** at least four pins (31, 31', 31 ") are provided for a contact with each insulating plate (8).

11. Electronic device according to claim 10, **characterized in that** the at least four pins (31, 31', 31 ") for the contact with each insulating plate (8) are arranged such that the at least four pins (31, 31', 31 ") are arranged outside the area, in which the at least one power electronic component is arranged, in particular the at least one insulating plate (8) is rectangular and the at least four pins (31) are arranged in the corners of each insulating plate (8).

12. Electronic device according to claim 11, **characterized in that** a further pin (31, 31', 31 ") is arranged in the middle point of each insulating plate (8).

13. Electronic device according to claim 2, **characterized in that** the pins (31, 31', 31 ") are arranged in a geometrical periodical structure.

14. Electronic device according to any of the preceding claims, in which the electronic device is a semiconductor module and the at least one power electronic component is at least one insulated gate bipolar transistor.

15. Electronic device according to claim 14, **characterized in that** at least two insulating plates (8) are metallurgical bonded on the base plate (1).

## Patentansprüche

1. Elektronische Vorrichtung, die mindestens eine Leistungselektronikkomponente umfasst, insbesondere mindestens einen Halbleiterchip (4), eine elektrisch isolierende Platte (8) und eine Basisplatte (1), wobei die Basisplatte eine Kühlplatte (2) umfasst, wobei die mindestens eine Leistungselektronikkomponente auf die elektrisch isolierende Platte (8), insbesondere auf ein Keramiksubstrat, metallurgisch gebondet wird, insbesondere durch Löten, Metall- oder Niedertemperaturbonden, wobei die elektrisch isolierende Platte (8) auf die Basisplatte (1) metallurgisch gebondet wird, insbesondere durch Löten oder Niedertemperaturbonden, und wobei Abstandshalterelemente (3) zwischen der isolierenden Platte (8) und der Kühlplatte (2) angeordnet sind, **dadurch gekennzeichnet, dass** die Basisplatte (1) die Abstandshalterelemente (3) umfasst, die auf der Oberfläche der Kühlplatte (2) angeordnet sind, wobei die Abstandshalterelemente (3) und die Kühlplatte (2) als ein Stück hergestellt sind und das Material in dem Oberflächengebiet der Kühlplatte (2) und der Abstandshalterelemente das gleiche ist.

2. Elektronische Vorrichtung nach Anspruch 1, **dadurch gekennzeichnet, dass** die Abstandshalterelemente (3) Stifte (31, 31', 31'') sind.

3. Elektronische Vorrichtung nach Anspruch 2, **dadurch gekennzeichnet, dass** die Stifte (31, 31', 31'') einen Querschnitt von unter 2 mm x 2 mm, insbesondere 1 mm x 1 mm, aufweisen.

4. Elektronische Vorrichtung nach Anspruch 2 oder 3, **dadurch gekennzeichnet, dass** sich die Stifte (31, 31', 31") von der Oberfläche der Kühlplatte (2) zu einer Höhe (32) zwischen 50 und 200 µm erstrecken.

5. Elektronische Vorrichtung nach Anspruch 2 oder 3, **dadurch gekennzeichnet, dass** die Stifte (31, 31', 31'') einen runden Querschnitt aufweisen, insbesondere einen kreisförmigen oder einen ovalen Querschnitt.

6. Elektronische Vorrichtung nach Anspruch 2 oder 3, **dadurch gekennzeichnet, dass** die Stifte (31, 31', 31'') einen viereckigen Querschnitt aufweisen, insbesondere einen quadratischen oder einen rechteckigen Querschnitt.

7. Elektronische Vorrichtung nach Anspruch 2 bis 6, **dadurch gekennzeichnet, dass** der Querschnitt der Stifte (31, 31', 31") mit dem Abstand von der Oberfläche der Kühlplatte (2) mindestens in dem oberen Bereich der Stifte (31, 31', 31 "), insbesondere in einem Längengebiet (33) zwischen 90 und 100% der Höhe (32) jedes Stifts (31, 31', 31''), insbesondere in einem Längengebiet (33) von 75 bis 100% der Höhe (32) jedes Stifts (31, 31', 31''), insbesondere in einem Längengebiet (33) von 50 bis 100% der Höhe (32) jedes Stifts (31, 31', 31'') und insbesondere über der ganzen Höhe (32) jedes Stifts (31, 31', 31'') abnimmt.

8. Elektronische Vorrichtung nach Anspruch 2 bis 7, **dadurch gekennzeichnet, dass** die Kühlplatte (2) ein erstes Rechteck (21) ist und die Stifte (31, 31', 31") in den vier Ecken der Kühlplatte (2) angeordnet sind, jeder insbesondere in einem Bereich entsprechend einem zweiten Rechteck (6), wobei sich das zweite Rechteck (6) auf der Oberfläche der Kühlplatte (2) von einer Ecke der Kühlplatte (2) mit einer Seitenlänge (61, 61') entsprechend einem Viertel der Seitenlänge (22, 22') der Kühlplatte (2) erstreckt, wobei die Seite der Kühlplatte (2) parallel zu der Seite des zweiten Rechtecks (6) liegt.

9. Elektronische Vorrichtung nach Anspruch 8, **dadurch gekennzeichnet, dass** ein Stift (31, 31', 31 ") in dem Mittelteil des ersten Rechtecks (21), insbesondere in einem Bereich um die Mitte herum entsprechend einem dritten Rechteck (7) mit einer Seitenlänge (71, 71') entsprechend einem Viertel der Seitenlänge (22, 22') der Kühlplatte (2) angeordnet ist, wobei die Seite der Kühlplatte (2) parallel zu der Seite des dritten Rechtecks (7) liegt, und insbesondere in der Mitte (23) des ersten Rechtecks (21).

10. Elektronische Vorrichtung nach Anspruch 2 bis 7, **dadurch gekennzeichnet, dass** die Basisplatte (1) an mindestens eine Isolierplatte (8) metallurgisch gebondet ist, jeweils mit mindestens einer Leistungselektronikkomponente angeordnet auf einer Seite gegenüber der Basisplatte (1), und dass mindestens vier Stifte (31, 31', 31") für einen Kontakt mit jeder Isolierplatte (8) vorgesehen sind.

11. Elektronische Vorrichtung nach Anspruch 10, **dadurch gekennzeichnet, dass** die mindestens vier Stifte (31, 31', 31") für den Kontakt mit jeder Isolierplatte (8) derart angeordnet sind, dass die mindestens vier Stifte (31, 31', 31") außerhalb des Bereichs angeordnet sind, in dem die mindestens eine Leistungselektronikkomponente angeordnet ist, insbesondere die mindestens eine Isolierplatte (8) rechteckig ist und die mindestens vier Stifte (31) in den Ecken jeder Isolierplatte (8) angeordnet sind.

12. Elektronische Vorrichtung nach Anspruch 11, **dadurch gekennzeichnet, dass** ein weiterer Stift (31, 31', 31") in dem Mittelpunkt jeder Isolierplatte (8) angeordnet ist.

13. Elektronische Vorrichtung nach Anspruch 2, **dadurch gekennzeichnet, dass** die Stifte (31, 31', 31") in einer geometrischen periodischen Struktur angeordnet sind.

14. Elektronische Vorrichtung nach einem der vorhergehenden Ansprüche, bei der die elektronische Vorrichtung ein Halbleitermodul ist und die mindestens eine Leistungselektronikkomponente mindestens ein Bipolartransistor mit isoliertem Gate ist.

15. Elektronische Vorrichtung nach Anspruch 14, **dadurch gekennzeichnet, dass** mindestens zwei Isolierplatten (8) metallurgisch auf die Basisplatte (1) gebondet sind.

## Revendications

1. Dispositif électronique comprenant au moins un composant électronique de puissance, en particulier au moins une puce semi-conductrice (4), une plaque électro-isolante (8) et une plaque de base (1), la plaque de base comprenant une plaque de refroidissement (2), l'au moins un composant électronique de puissance étant fixé par liaison métallurgique, en particulier par brasage, liaison métallique ou liaison à basse température, sur la plaque électro-isolante (8), en particulier sur un substrat céramique, ladite plaque électro-isolante (8) étant fixée par liaison métallurgique, en particulier par brasage ou liaison à basse température, sur la plaque de base (1), et des éléments d'espacement (3) étant agencés entre la plaque isolante (8) et la plaque de refroidissement (2), **caractérisé en ce que** la plaque de base (1) comprend les éléments d'espacement (3), qui sont agencés sur la surface de la plaque de refroidissement (2), les éléments d'espacement (3) et la plaque de refroidissement (2) étant réalisés d'une seule pièce et le matériau employé dans la région de surface de la plaque de refroidissement (2) et des éléments d'espacement étant le même.

2. Dispositif électronique selon la revendication 1, **caractérisé en ce que** les éléments d'espacement (3) sont des picots (31, 31' 31").

3. Dispositif électronique selon la revendication 2, **caractérisé en ce que** les picots (31 31' 31") ont une section transversale inférieure à 2 mm x 2 mm, en particulier 1 mm x 1 mm.

4. Dispositif électronique selon la revendication 2 ou 3, **caractérisé en ce que** les picots (31, 31', 31") s'étendant depuis la surface de la plaque de refroidissement (2) jusqu'à une hauteur (32) comprise entre 50 et 200 µm.

5. Dispositif électronique selon la revendication 2 ou 3, **caractérisé en ce que** les picots (31, 31', 31") ont une section transversale ronde, en particulier une section transversale circulaire ou ovale.

6. Dispositif électronique selon la revendication 2 ou 3, **caractérisé en ce que** les picots (31, 31', 31") ont une section transversale quadrangulaire, en particulier une section transversale carrée ou rectangulaire.

7. Dispositif électronique selon les revendications 2 à 6, **caractérisé en ce que** la section transversale des picots (31, 31', 31") diminue avec l'éloignement de la surface de la plaque de refroidissement (2) au moins dans la zone supérieure des picots (31, 31', 31"), en particulier dans une région longitudinale (33) entre 90 et 100% de la hauteur (32) de chaque picot (31, 31', 31"), en particulier dans une région longitudinale (33) de 75 à 100% de la hauteur (32) de chaque picot (31, 31', 31"), en particulier dans une région longitudinale (33) de 50 à 100% de la hauteur (32) de chaque picot (31, 31', 31"), et en particulier sur toute la hauteur (32) de chaque picot (31, 31', 31").

8. Dispositif électronique selon les revendications 2 à 7, **caractérisé en ce que** la plaque de refroidissement (2) est un premier rectangle (21) et les picots (31, 31', 31") sont agencés aux quatre coins de la plaque de refroidissement (2), chacun en particulier dans une zone correspondant à un second rectangle (6), ledit second rectangle (6) s'étendant sur la surface de la plaque de refroidissement (2) depuis un coin de la plaque de refroidissement (2), avec une longueur de côté (61, 61') correspondant à un quart de la longueur de côté (22, 22') de la plaque de refroidissement (2), ledit côté de la plaque de refroidissement (2) étant parallèle au côté du second rectangle (6).

9. Dispositif électronique selon la revendication 8, **caractérisé en ce qu'**un picot (31, 31', 31") est agencé dans la partie centrale du premier rectangle (21), en particulier dans une zone autour du centre correspondant à un troisième rectangle (7), avec une longueur de côté (71, 71') correspondant à un quart de la longueur de côté (22, 22') de la plaque de refroidissement (2), ledit côté de la plaque de refroidissement (2) étant parallèle au côté du troisième rectangle (7), et en particulier au centre (23) du premier rectangle (21).

10. Dispositif électronique selon les revendications 2 à 7, **caractérisé en ce que** la plaque de base (1) est fixée par liaison métallurgique à au moins une plaque isolante (8), chacune ayant au moins un composant électronique de puissance agencé sur un côté opposé à la plaque de base (1), et **en ce qu'**au moins quatre picots (31, 31', 31") sont prévus en vue d'assurer un contact avec chaque plaque isolante (8).

11. Dispositif électronique selon la revendication 10, **caractérisé en ce que** les au moins quatre picots (31, 31', 31"), destinés à assurer le contact avec chaque plaque isolante (8), sont agencés de telle sorte que les au moins quatre picots (31, 31', 31") soient agencés à l'extérieur de la zone dans laquelle est agencé l'au moins un composant électronique de puissance, l'au moins une plaque isolante (8) en particulier étant rectangulaire et les au moins quatre picots (31) étant agencés dans les coins de chaque plaque isolante (8).

12. Dispositif électronique selon la revendication 11, **caractérisé en ce qu'**un autre picot (31, 31', 31") est agencé au milieu de chaque plaque isolante (8) .

13. Dispositif électronique selon la revendication 2, **caractérisé en ce que** les picots (31, 31', 31") sont agencés en une structure géométrique périodique.

14. Dispositif électronique selon l'une quelconque des revendications précédentes, dans lequel le dispositif électronique est un module semiconducteur et l'au moins un composant électronique de puissance est au moins un transistor bipolaire à porte isolée.

15. Dispositif électronique selon la revendication 14, **caractérisé en ce qu'**au moins deux plaques isolantes (8) sont fixées par liaison métallurgique sur la plaque de base (1).
